(19)

Europäisches Patentamt
European Patent Office
Office européen des brevets

(11) **EP 4 228 122 A1**

(12) **EUROPEAN PATENT APPLICATION**
published in accordance with Art. 153(4) EPC

(43) Date of publication:
**16.08.2023 Bulletin 2023/33**

(21) Application number: **21884510.5**

(22) Date of filing: **19.07.2021**

(51) International Patent Classification (IPC):
*H02J 50/30* (2016.01)    *H01S 5/14* (2006.01)

(52) Cooperative Patent Classification (CPC):
**H01S 3/101; H01S 5/14; H02J 7/35; H02J 50/30**

(86) International application number:
**PCT/CN2021/107151**

(87) International publication number:
**WO 2022/088774 (05.05.2022 Gazette 2022/18)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **02.11.2020 CN 202011204598**

(71) Applicant: **Huawei Technologies Co., Ltd.**
**Shenzhen, Guangdong 518129 (CN)**

(72) Inventors:
• LIU, Ce
  **Shenzhen, Guangdong 518129 (CN)**
• LU, Zefeng
  **Shenzhen, Guangdong 518129 (CN)**
• WANG, Mingqiang
  **Shenzhen, Guangdong 518129 (CN)**
• LIU, Yanding
  **Shenzhen, Guangdong 518129 (CN)**

(74) Representative: **Gill Jennings & Every LLP**
**The Broadgate Tower**
**20 Primrose Street**
**London EC2A 2ES (GB)**

(54) **LASER EMITTING APPARATUS, LASER EMITTING METHOD AND LASER WIRELESS CHARGING SYSTEM**

(57)    A laser emitting apparatus (41), a laser emitting method, and a laser wireless charging system are disclosed. The laser emitting apparatus (41) includes: a detection and control module (414, 415), a pump source (411), and a first reflecting mirror group (413), a gain medium (412), and a beam deflection module (416) that are disposed on an optical path. The gain medium (412) is pumped by the pump source (411) to emit fluorescence, and is stimulated by resonance, between the first reflecting mirror group (413) and a laser receiving apparatus (42), of the fluorescence to emit laser light. The beam deflection module (416) emits the fluorescence or the laser light emitted by the gain medium (412), and emits the fluorescence or the laser light reflected by the laser receiving apparatus (42) into the gain medium (412). The detection and control module (414, 415) adjusts the beam deflection module (416) to a plurality of preset emission angles, detects light intensities of the fluorescence or the laser light at the plurality of preset emission angles, and a light spot position, of the laser light, on the detection and control module (414, 415), and if the light intensity is greater than a first threshold at any preset emission angle, adjusts the emission angle of the beam deflection module (416) based on the light spot

position, so that a range in which the laser emitting apparatus tracks the laser receiving apparatus (42) is expanded in the field of wireless charging.

FIG. 6

## Description

This application claims priority to Chinese Patent Application No. 202011204598.8, filed with the China National Intellectual Property Administration on November 2, 2020 and entitled "LASER EMITTING APPARATUS, LASER EMITTING METHOD, AND LASER WIRELESS CHARGING SYSTEM", which is incorporated herein by reference in its entirety.

## TECHNICAL FIELD

This application relates to the field of laser wireless charging, and in particular, to a laser emitting apparatus, a laser emitting method, and a laser wireless charging system.

## BACKGROUND

A laser wireless charging technology is a long-distance wireless charging technology, to be specific, a laser emitting apparatus emits laser light to a laser receiving apparatus, and after receiving the laser light, the laser receiving apparatus converts the laser light into electric energy and performs charging.

In a practical application, the laser receiving apparatus moves relative to the laser emitting apparatus, so the laser emitting apparatus needs to scan and track a position of the laser receiving apparatus. For a laser wireless charging system in which a laser emitting apparatus and a laser receiving apparatus transmit laser light by forming resonance, a range in which the laser emitting apparatus emits the laser light is very small due to a stability limitation of the resonance. As a result, it is likely that the laser receiving apparatus cannot receive the laser light.

## SUMMARY

Embodiments of this application provide a laser emitting apparatus, a laser emitting method, and a laser wireless charging system, to expand a range in which the laser emitting apparatus tracks a laser receiving apparatus.

To achieve the foregoing objectives, the following technical solutions are used in embodiments of this application.

According to a first aspect, a laser emitting apparatus is provided, including: a detection and control module, a pump source, and a first reflecting mirror group, a gain medium, and a beam deflection module that are disposed on an optical path. The gain medium is pumped by the pump source to emit fluorescence, and is stimulated by resonance, between the first reflecting mirror group and a laser receiving apparatus, of the fluorescence to emit laser light. The beam deflection module is configured to: emit the fluorescence or the laser light emitted by the gain medium, and emit the fluorescence or the laser light reflected by the laser receiving apparatus into the gain medium. The detection and control module is configured to: sequentially adjust the beam deflection module to a plurality of preset emission angles, that is, scan the laser receiving apparatus by emitting laser light in a specific area; detect light intensities of the fluorescence or the laser light at the plurality of preset emission angles, and a light spot position, of the laser light, on the detection module; and if the light intensity is greater than a first threshold at any preset emission angle, that is, the laser light generates the resonance between the first reflecting mirror group and the laser receiving apparatus, adjust the emission angle of the beam deflection module based on the light spot position, so that the laser light emitted by the beam deflection module is aimed at the laser receiving apparatus, that is, fine adjustment is performed. According to the laser emitting apparatus provided in this embodiment of this application, the beam deflection module can adjust the emission angle of the laser light by a large angle, and does not need to be limited by a reflection range of the reflecting mirror and stability of a resonant cavity. Therefore, a laser light emission range of the laser emitting apparatus can be increased.

In a possible implementation, the detection and control module includes a control module and a detection module, and the control module is configured to adjust, in a direction in which a deviation between the light spot position and a center of the detection module is reduced, the emission angle of the beam deflection module until an absolute value of the deviation between the light spot position and the center of the detection module is less than or equal to a second threshold. This implementation discloses how the control module specifically finely controls the emission angle of the beam deflection module. A closer light spot position to the center of the detection module indicates higher power of the laser light.

In a possible implementation, the beam deflection module includes a first galvanometer scanner and a second galvanometer scanner; the fluorescence or the laser light from the gain medium is sequentially reflected by the first galvanometer scanner and the second galvanometer scanner and then emitted, and the fluorescence or the laser light emitted from the laser emitting apparatus is sequentially reflected by the second galvanometer scanner and the first galvanometer scanner and then transmitted back to the gain medium; and the control module adjusts the emission angle of the beam deflection module by controlling rotation angles of the first galvanometer scanner and the second galvanometer scanner. This implementation discloses a possible structure of the beam deflection module. A scanning angle may be adjusted by adjusting the rotation angles of the first galvanometer scanner and the second galvanometer scanner, or a direction of the laser light emitted by the laser emitting apparatus may be finely adjusted to be aimed at the laser receiving apparatus.

In a possible implementation, the laser emitting apparatus further includes a first lens group, the first lens group is disposed on the optical path between the gain medium and the beam deflection module, and the first lens group is configured to adjust a working distance and field of view of a stability zone of the laser light. Stability of a resonant cavity at different distances and in different angle ranges may be changed by changing an optical parameter, for example, a focal length or a zoom-in ratio of the lens, of the first lens group. For example, a smaller zoom-in ratio indicates a shorter working distance of the stability zone, but a larger field of view of the stability zone. A larger zoom-in ratio indicates a longer working distance of the stability zone, but a smaller field of view of the stability zone. For another example, a longer focal length indicates a longer working distance of the stability zone, but a smaller field of view of the stability zone. A shorter focal length indicates a shorter working distance of the stability zone, but a larger field of view of the stability zone.

In a possible implementation, the laser emitting apparatus further includes a partial reflecting mirror, the partial reflecting mirror is disposed on the optical path between the gain medium and the beam deflection module, and the partial reflecting mirror can partially reflect the fluorescence or the laser light to the gain medium. The partial reflecting mirror can partially reflect fluorescence or laser light of a first wavelength to the gain medium, so that a pumping power threshold of a resonant cavity of the laser light of the first wavelength can be reduced. A light intensity of the fluorescence reflected by the partial reflecting mirror is weak, and a reflectivity of the partial reflecting mirror multiplied by a gain coefficient of the gain medium is less than 1, so that no resonance is formed between the partial reflecting mirror and the first reflecting mirror when there is no reflection by the laser receiving apparatus. When the laser receiving apparatus reflects the light of the first wavelength, a gain in a resonant cavity is greater than a loss, and resonance may be generated in the resonant cavity and the laser light of the first wavelength may be emitted.

In a possible implementation, the pump source and the gain medium are disposed together as an electric pump semiconductor gain chip, which can reduce a volume of the laser emitting apparatus.

According to a second aspect, a laser emitting method is provided, applied to the laser emitting apparatus according to any one of the first aspect and the implementations of the first aspect. The method includes: sequentially adjusting a beam deflection module of the laser emitting apparatus to a plurality of preset emission angles; detecting light intensities of fluorescence or laser light at the plurality of preset emission angles, and a light spot position, of the laser light, on a detection and control module of the laser emitting apparatus; and if the light intensity is greater than a first threshold at any preset emission angle, adjusting the emission angle of the beam deflection module based on the light spot position, so that laser light emitted by the beam deflection module is aimed at a laser receiving apparatus.

In a possible implementation, the adjusting the emission angle of the beam deflection module based on the light spot position includes: adjusting, in a direction in which a deviation between the light spot position and a center of the detection module of the detection and control module is reduced, the emission angle of the beam deflection module until an absolute value of the deviation between the light spot position and the center of the detection module is less than or equal to a second threshold.

According to a third aspect, a laser wireless charging system is provided, including the laser emitting apparatus and the laser receiving apparatus according to any one of the first aspect and the implementations of the first aspect. The laser receiving apparatus includes a second reflecting mirror group, a laser photovoltaic cell, a power conversion circuit, and a load circuit. The second reflecting mirror group is configured to: reflect a part of fluorescence or laser light from a beam deflection module of the laser emitting apparatus back to the beam deflection module, and transmit the other part to the laser photovoltaic cell; and the power conversion circuit is configured to perform power conversion on electric energy from the laser photovoltaic cell, and output the electric energy to the load circuit.

For technical effect of the second aspect and the third aspect, refer to the technical effect of any one of the first aspect and the implementations of the first aspect. Details are not repeated herein.

## BRIEF DESCRIPTION OF DRAWINGS

FIG. 1 is a schematic diagram 1 of an architecture of a laser wireless charging system according to an embodiment of this application;

FIG. 2 is a schematic diagram of a principle of a laser according to an embodiment of this application;

FIG. 3 is a schematic diagram of a structure of a reflecting mirror group according to an embodiment of this application;

FIG. 4 is a schematic diagram 2 of an architecture of a laser wireless charging system according to an embodiment of this application;

FIG. 5 is a schematic diagram of a fluorescence range and a field of view range according to an embodiment of this application;

FIG. 6 is a schematic diagram 3 of an architecture of a laser wireless charging system according to an embodiment of this application;

FIG. 7 is a schematic diagram 4 of an architecture of a laser wireless charging system according to an embodiment of this application;

FIG. 8 is a schematic diagram 5 of an architecture of a laser wireless charging system according to an embodiment of this application;

FIG. 9 is a schematic diagram 1 of a structure of a laser emitting apparatus according to an embodiment of this application;

FIG. 10 is a schematic diagram 2 of a structure of a laser emitting apparatus according to an embodiment of this application;

FIG. 11 is a schematic diagram 3 of a structure of a laser emitting apparatus according to an embodiment of this application;

FIG. 12 is a schematic diagram of a structure of a four-quadrant photoelectric detector according to an embodiment of this application;

FIG. 13 is a schematic diagram of controlling rotation angles of a first galvanometer scanner and a second galvanometer scanner according to an embodiment of this application; and

FIG. 14 is a schematic diagram of a scanning manner according to an embodiment of this application.

## DESCRIPTION OF EMBODIMENTS

A laser wireless energy transmission technology is a technology in which a laser emitting apparatus transmits energy outwards by using laser light as a carrier, and a laser receiving apparatus receives the laser light and converts the laser light into electric energy. Compared with an electromagnetic wireless energy transmission technology, the laser wireless energy transmission technology has better directivity and a longer transmission distance.

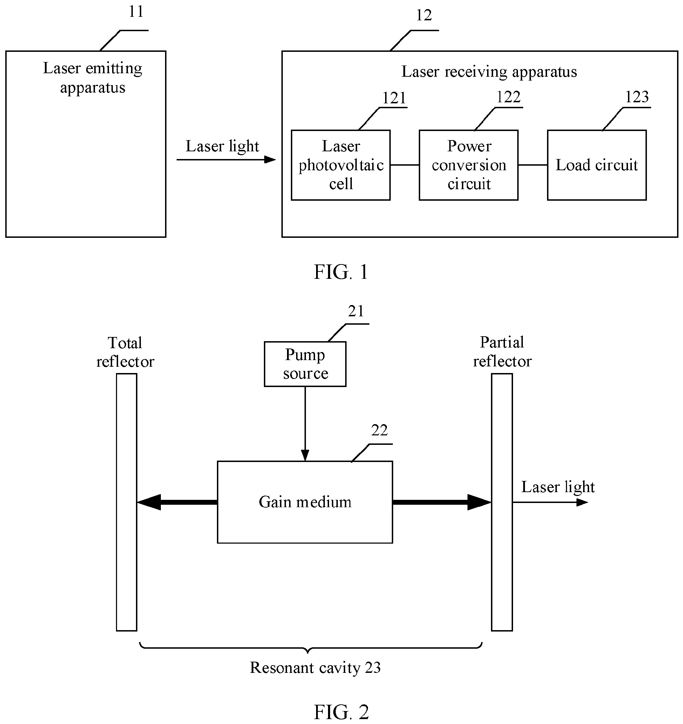

The laser wireless energy transmission technology is applied to charging the laser receiving apparatus, which is referred to as a laser wireless charging technology. As shown in FIG. 1, a laser wireless charging system includes a laser emitting apparatus 11 and a laser receiving apparatus 12. The laser receiving apparatus 12 includes a laser photovoltaic cell 121, a power conversion circuit 122, and a load circuit 123. The laser emitting apparatus 11 generates laser light of a specific wavelength, the laser photovoltaic cell 121 converts laser light energy into electric energy after receiving the laser light, and the power conversion circuit 122 converts a voltage generated by the laser photovoltaic cell into a voltage required by the load circuit 123, to supply power to the load circuit 123.

The laser emitting apparatus may be a device that can emit laser light, such as a laser wireless charger or a laser emitting tower. The laser receiving apparatus may be a device that can receive laser light and can convert the laser light into electric energy, such as a mobile phone or an electric vehicle.

The laser emitting apparatus is usually evolved from a laser. Therefore, a basic working principle of the laser is first described.

As shown in FIG. 2, a laser includes a pump source 21, a gain medium (also referred to as a working substance) 22, and a resonant cavity 23. The pump source 21 is used as an energy source and is configured to provide energy to the gain medium 22. The gain medium 22 is pumped to emit and amplify laser light of a specific wavelength. The laser light oscillates and reciprocates in the resonant cavity 23 and is enhanced in the gain medium 22. Then, the laser light is output at one end of the resonant cavity 23.

The pump source 21 includes an optical pump source, an electric pump source, and the like. A common pump source is semiconductor laser pump source, which implements conversion from electric energy to light energy.

Types of the gain medium 22 include liquid, gas, and solid. The liquid includes, for example, an organic solution, the gas includes, for example, carbon dioxide, and the solid includes, for example, a semiconductor, a crystalline material (for example, neodymium-doped yttrium aluminum garnet (Nd: YAG) crystal), and the like.

The resonant cavity 23 includes two reflecting mirror groups, and a photon reflects back and forth between the two reflecting mirror groups, and continuously causes stimulated radiation in the gain medium, to generate laser light with a high light intensity. The reflecting mirror group is used to return incident light along an original path or in parallel. One reflecting mirror group in the resonant cavity is made into a total reflecting mirror, and the other reflecting mirror group is made into a partial reflecting mirror. In this way, a part of the laser light can be output from the other side of the partial reflecting mirror.

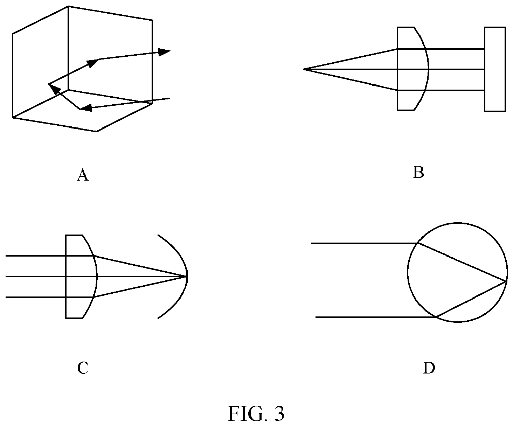

As shown in FIG. 3, a structure of the reflecting mirror group is not limited in this application. The reflecting mirror group may be, for example, a corner reflector shown in A in FIG. 3, a mirror group including a convex lens and a planar mirror shown in B in FIG. 3, a mirror group including a convex lens and a concave mirror shown in C in FIG. 3, a near-spherical retroreflector with a refractive index greater than or equal to 1.9 and less than or equal to 2.1 shown in D in FIG. 3, or the like.

A process of emitting a photon by the gain medium 22 includes spontaneous emission and stimulated radiation, and therefore light emitted by the gain medium 22 also includes fluorescence and laser light.

After the gain medium 22 is pumped by the pump source 21, upper energy level population inversion occurs (that is, a quantity of atoms at a high energy level E2 is greater than a quantity of atoms at a low energy level E1), and the inverted upper energy level particle can emit a photon to return to a ground state. The process is the spontaneous emission, and the light is the fluorescence. When the resonant cavity 23 does not form resonance, the fluorescence of the spontaneous emission is dominant, and the fluorescence of the spontaneous emission has a solid angle of $4\pi$ (that is, emission in all directions, without directionality).

After the resonant cavity starts to resonate, the gain medium 22 is stimulated by the fluorescence reflected in the resonant cavity, amplifies the light, and continues to emit the light in an original direction. This process is the stimulated radiation. The amplified light is the laser light, and an emission direction of the amplified light is the same as a direction of incident light. Therefore, the amplified light has good directionality. When the resonant cavity starts to resonate, the spontaneous emission is greatly weakened, an intensity of the fluorescence is reduced, and an intensity of the laser light is increased.

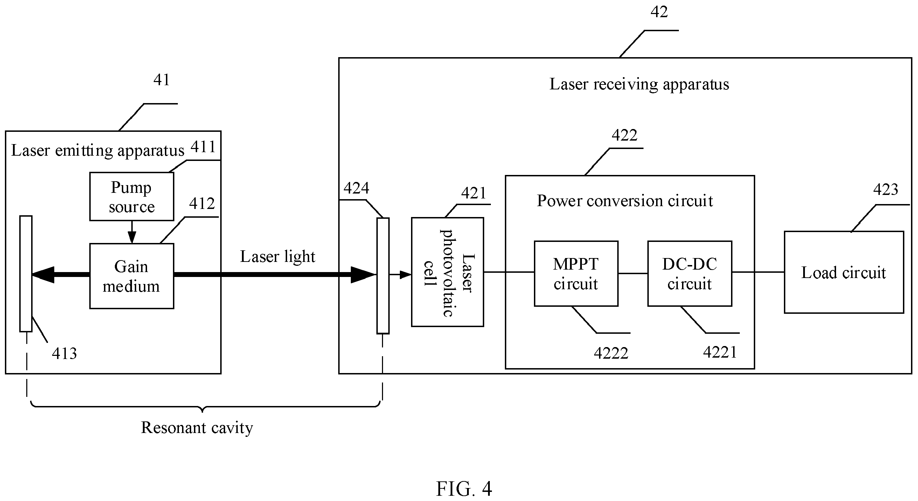

The laser including the two reflecting mirror groups is used in the field of laser wireless charging. As shown in FIG. 4, an embodiment of this application provides a laser wireless charging system, including a laser emitting apparatus 41 and a laser receiving apparatus 42. The laser emitting apparatus 41 includes a pump source 411, a gain medium 412, and a first reflecting mirror group 413. The laser receiving apparatus 42 includes a laser photovoltaic cell 421, a power conversion circuit 422, a load circuit 423, and a second reflecting mirror group 424. The power conversion circuit 422 includes a direct current-direct current (direct current-direct current, DC-DC) circuit 4221, and optionally, further includes a maximum power point tracking (maximum power point tracking, MPPT) circuit 4222.

A working principle of the laser wireless charging system is as follows:

The first reflecting mirror group 412 and the second reflecting mirror group 424 form a resonant cavity. The first reflecting mirror group 412 is a total reflecting mirror, and the second reflecting mirror group 424 is a partial reflecting mirror. The pump source 411 is used as an energy source to provide energy for the gain medium 412. The gain medium 412 is pumped to emit and amplify laser light of a specific wavelength. The laser light oscillates and reciprocates in the resonant cavity, and a part of the laser light is emitted from the other side of the second reflecting mirror group 412. The laser photovoltaic cell 421 converts laser light energy into electric energy after receiving the laser light, and the power conversion circuit 422 converts a voltage generated by the laser photovoltaic cell into a voltage required by the load circuit 423, to supply power to the load circuit 423.

The MPPT circuit 4222 in the power conversion circuit 422 is configured to implement maximum power tracking, so that the laser photovoltaic cell 421 outputs maximum electric power, and the MPPT 4222 is usually a boost (boost) circuit. The DC-DC circuit 4221 is configured to convert a voltage output by the MPPT circuit 4222 into the voltage required by the load circuit. The DC-DC circuit 4221 may be a circuit that has a voltage conversion function, such as a buck (buck) circuit, a boost (boost) circuit, or a buck-boost (buck-boost) circuit.

Because the reflecting mirror can return incident light along an original path or in parallel within a specific range, energy transmission can be implemented as long as the first reflecting mirror group, the second reflecting mirror group, and the gain medium are approximately in a straight line, and automatic positioning and tracking of the laser receiving apparatus can be implemented within a specific range. When someone enters the optical path, the resonance of the laser light in the resonant cavity stops, so that no harm is caused to the person.

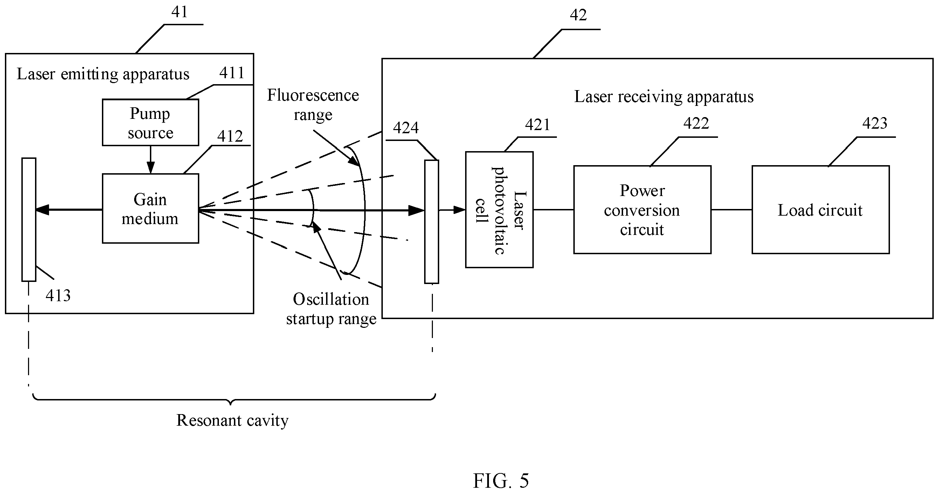

However, due to a limitation of a reflection range of the reflecting mirror and a limitation of stability of the resonant cavity, the scanning and tracking range is not large enough. As shown in FIG. 5, the gain medium 412 is pumped to emit fluorescence within a specific fluorescence range. Limited by the stability of the resonant cavity, the second reflecting mirror group 424 cannot form the resonant cavity with the first reflecting mirror group 413 all within the fluorescence range, and instead, may form the resonant cavity with the first reflecting mirror group 413 in a field of view range smaller than the fluorescence range. When the second reflecting mirror group 424 (that is, the laser receiving apparatus 42) moves within the field of view range, the laser light is received due to the resonance. When the second reflecting mirror group 424 (that is, the laser receiving apparatus 42) moves out of the field of view range, the laser light cannot be received because the resonance stops.

Therefore, an embodiment of this application provides another laser wireless charging system. A beam deflection module is added to a laser emitting apparatus, to expand a field of view range. A laser receiving apparatus is scanned within the field of view range. The laser emitting apparatus detects a light intensity of fluorescence or laser light and a light spot position on a detection module. When the laser receiving apparatus is within the field of view range, the laser emitting apparatus and the laser receiving apparatus form a resonant cavity, and the laser emitting apparatus generates the laser light. In this case, the light intensity of the laser light is stronger than a threshold, to implement coarse positioning. Then the laser emitting apparatus adjusts the beam deflection module based on the light spot position, of the laser light, on the detection module, to adjust laser power generated by the laser emitting apparatus. The beam deflection module can adjust an emission angle of the laser light by a large angle, and a limitation of a reflection range of a reflecting mirror and a limitation of stability of the resonant cavity are removed. Therefore, a laser light emission range of the laser emitting apparatus can be expanded, and a range in which the laser emitting apparatus tracks the laser receiving apparatus is expanded.

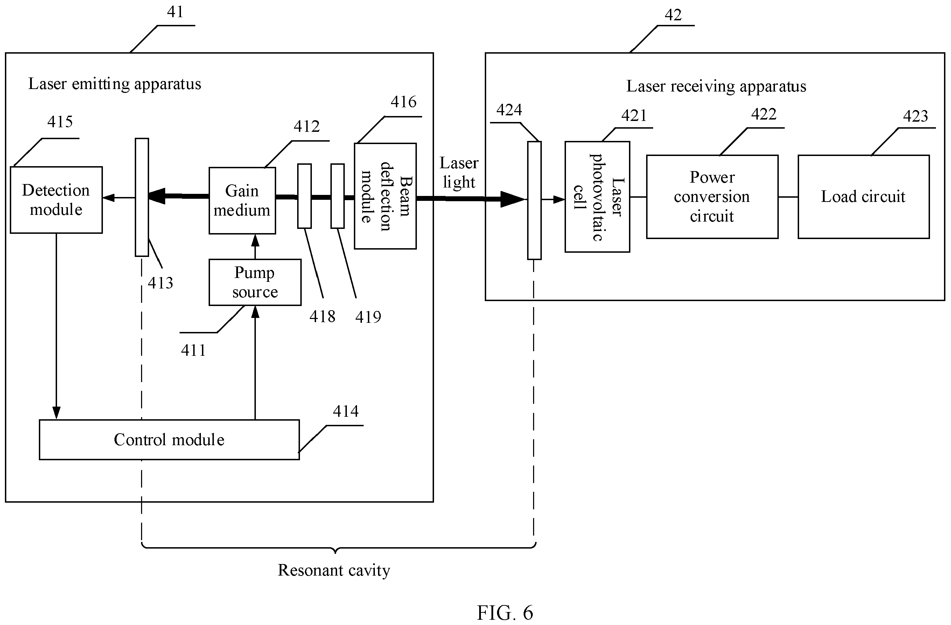

As shown in FIG. 6 to FIG. 8, based on the laser wireless charging system shown in FIG. 4, the laser emitting apparatus 41 may include a detection and control module (including a control module 414 and a detection module 415), a pump source 411, and the first reflecting mirror group 413, the gain medium 412, and the beam deflection module 416 that are sequentially disposed on the optical path of the resonant cavity. The control module 414 is electrically connected to the detection module 415, the pump source 411, and the beam deflection module 416.

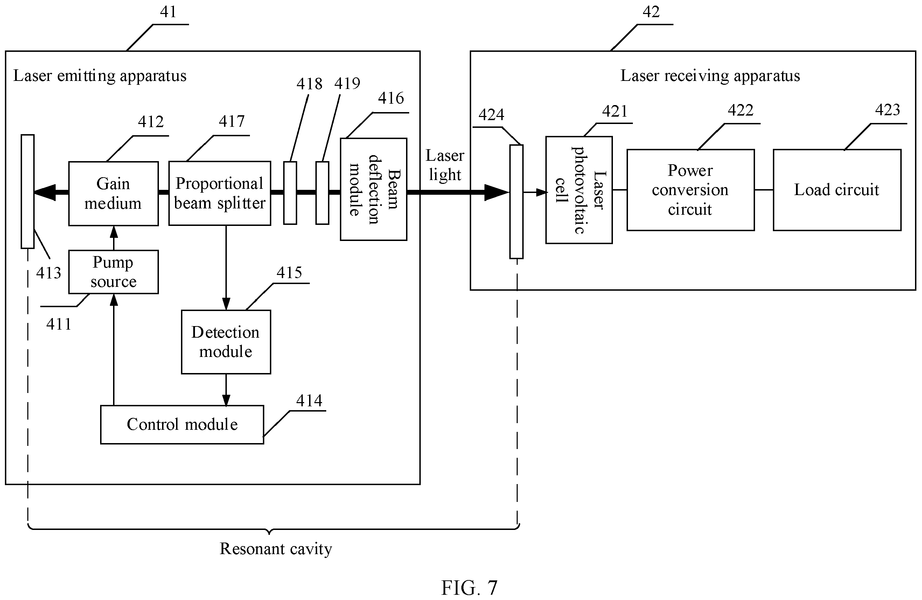

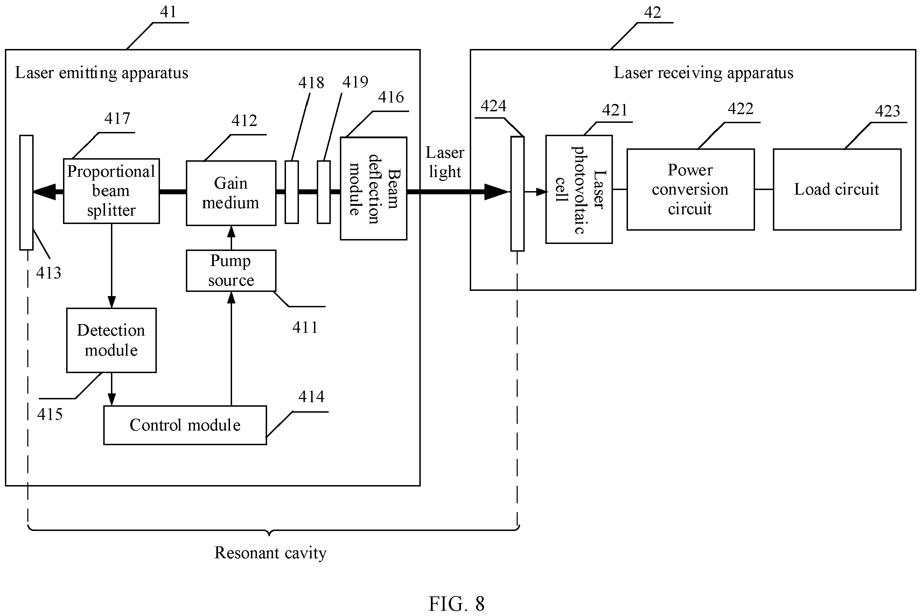

Optionally, as shown in FIG. 7 and FIG. 8, the laser emitting apparatus 41 may further include a proportional beam splitter 417 disposed in the resonant cavity, and the proportional beam splitter 417 may be disposed on the optical path between the gain medium 412 and the beam deflection module 416 (FIG. 7), or may be disposed on the optical path between the first reflecting mirror group 413 and the gain medium 412 (FIG. 8).

Optionally, as shown in FIG. 6 to FIG. 8, the laser emitting apparatus 41 may further include a first lens group 418, and the first lens group 418 may be disposed on the optical path between the gain medium 412 and the beam deflection module 416.

Optionally, as shown in FIG. 6 to FIG. 8, the laser emitting apparatus 41 may further include a partial reflecting mirror 419, and the partial reflecting mirror 419 may be disposed on the optical path between the gain medium 412 and the beam deflection module 416.

Functions of all components are described as follows:

The gain medium 412 is pumped by the pump source 411 to emit fluorescence of a first wavelength (for example, 1064 nm) to the first reflecting mirror group 413 and the beam deflection module 416. After reflecting the fluorescence of the first wavelength from the gain medium 412 back to the gain medium, the first reflecting mirror group 413 emits the fluorescence through the beam deflection module 416, and may emit the fluorescence to the laser receiving apparatus 42. After reflecting the fluorescence of the first wavelength emitted from outside of the apparatus (for example, reflected from the laser receiving apparatus 42) back to the gain medium 412, the beam deflection module 416 transmits the fluorescence to the first reflecting mirror group 413. When resonance is not formed between the laser receiving apparatus 42 and the laser emitting apparatus 41, the gain medium 412 emits the fluorescence, a part of the fluorescence is reflected by the beam deflection module 416 to the outside of the laser emitting apparatus 41, and the part of the fluorescence is very weak and safe for a human body.

The gain medium 412 is further stimulated by resonance, between the first reflecting mirror group 413 and the laser receiving apparatus 42 (the second reflecting mirror group 424), of the fluorescence to emit laser light. Similar to the fluorescence, after reflecting the laser light of a first wavelength from the gain medium 412 back to the gain medium, the first reflecting mirror group 413 emits the laser light through the beam deflection module 416, and may emit the laser light to the laser receiving apparatus 42. After reflecting the laser light of the first wavelength emitted from the outside of the apparatus (for example, reflected from the laser receiving apparatus 42) back to the gain medium 412, the beam deflection module 416 transmits the laser light to the first reflecting mirror group 413.

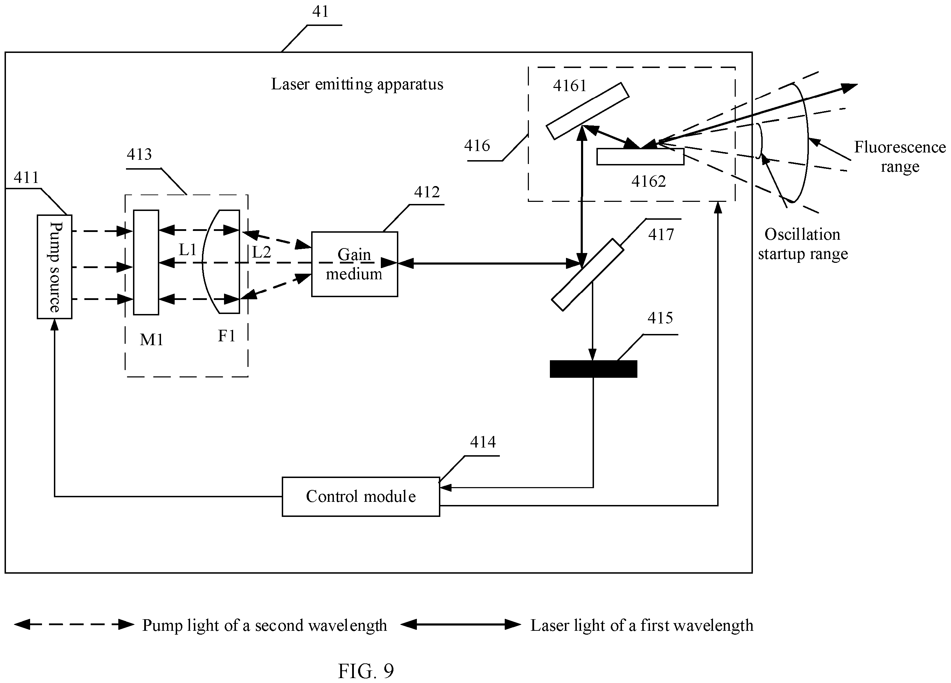

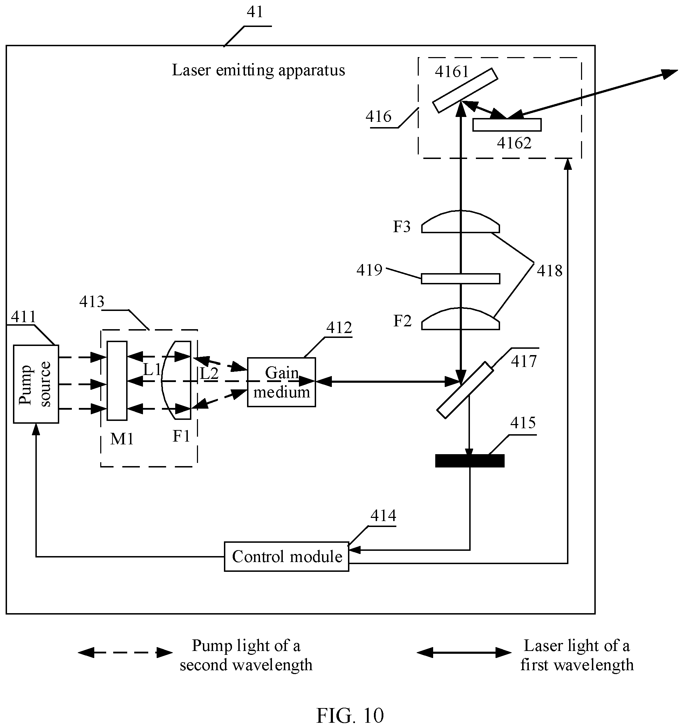

Optionally, as shown in FIG. 9 and FIG. 10, the pump source 411 and the gain medium 412 may be separately disposed. For example, the pump source 411 may be an optical pump source, and the pump source 411 emits pump light of a second wavelength (for example, 808 nm) to the gain medium 412. The gain medium 412 is stimulated by the pump light of the second wavelength to emit the fluorescence or the laser light of the first wavelength to the first reflecting mirror group 413 and the beam deflection module 416.

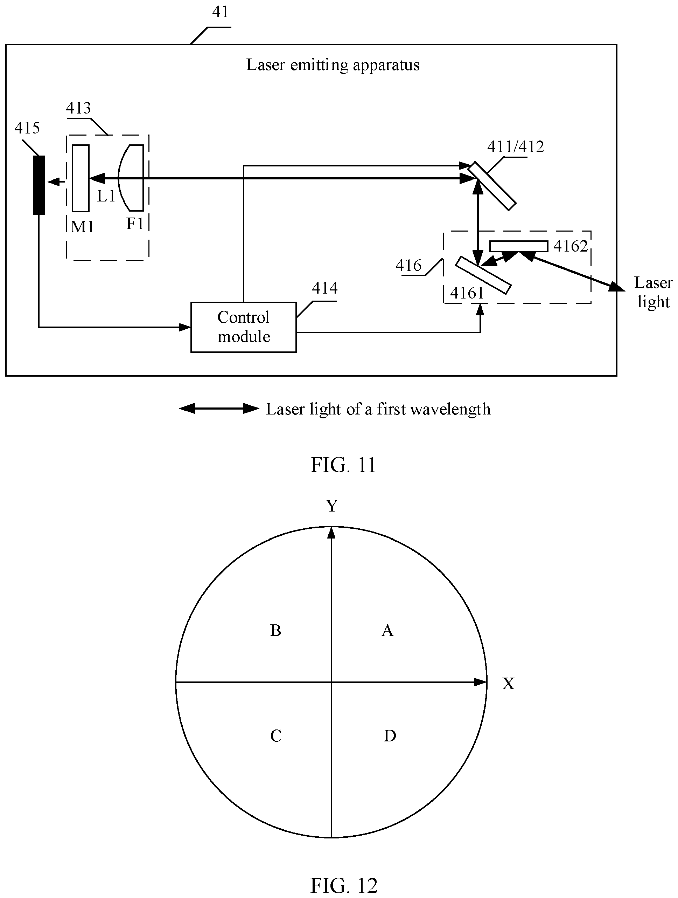

Optionally, as shown in FIG. 11, the pump source 411 and the gain medium 412 may be disposed together. For example, the pump source 411 and the gain medium 412 may be an electric pump semiconductor gain chip.

Optionally, as shown in FIG. 9 to FIG. 11, the first reflecting mirror group 413 may include a convex lens F1 and a planar mirror M1. A distance L1 between the convex lens F1 and the planar mirror M1 is approximately equal to a focal length f1 of the convex lens F1, and a distance L2 between the convex lens F1 and the gain medium is approximately equal to a focal length f1 of the convex lens F1.

Optionally, as shown in FIG. 9 and FIG. 10, high-transmitting films for the second wavelength may be grown on two sides of the planar mirror M1 (for example, anti-reflective (anti-reflective, AR) high-transmitting films), one side (reflective surface) of the planar mirror M1 may be grown with a high-reflective film (for example, a high-reflective (high-reflective, HR) low-transmitting film) for the first wavelength. High-transmitting films for the first wavelength and the second wavelength may be grown on two sides of the convex lens F1. In this way, the pump light of the second wavelength emitted by the pump source 411 can be irradiated to the gain medium 412 through the planar mirror M1 and the convex lens F1, and the fluorescence or the laser light of the first wavelength emitted by the gain medium 412 is reflected back to the gain medium 412.

Optionally, as shown in FIG. 9 and FIG. 10, a high-transmitting film for the first wavelength and the second wavelength may be grown on a first side of the gain medium 412, and a high-transmitting film for the first wavelength and a high-reflective film for the second wavelength may be grown on a second side of the gain medium 412. The first side of the gain medium 412 is a side facing the first reflecting mirror group 413, and the second side of the gain medium 412 is an opposite side of the first side. In this way, the pump light of the second wavelength can enter the gain medium 412 from the first side without leakage from the second side, and the fluorescence or the laser light of the first wavelength can be emitted from or emitted into the first side and the second side.

Optionally, as shown in FIG. 6, the first reflecting mirror group 413 is further configured to transmit a part of the fluorescence or the laser light of the first wavelength to the detection module 415. For example, as shown in FIG. 11, the planar mirror M1 may be a partial reflecting mirror. For example, a transmittance may be 5%, and a reflectivity may be 95%. High-transmitting films for the first wavelength may be grown on two sides of the convex lens F 1, so that the part of the fluorescence or the laser light of the first wavelength can be transmitted to the detection module 415 through the planar mirror M1.

Optionally, as shown in FIG. 11, a high-transmitting film for the first wavelength may be grown on an incident surface of the gain medium 412 (or referred to as an emergent surface), and a high-reflective film for the first wavelength may be grown on a reflective surface of the gain medium 412 (a joint surface with the pump source 411). In this way, the fluorescence or the laser light of the first wavelength can be emitted from or emitted into the gain medium, and a loss of the fluorescence or the laser light of the first wavelength in the gain medium is reduced.

The proportional beam splitter 417 is configured to transmit the part (for example, 4%) of the fluorescence or the laser light of the first wavelength to the detection module 415, and the other part (for example, 96%) is reflected at a specific angle. The reflected part resonates between the first reflecting mirror group 413 and the beam deflection module 416. For example, as shown in FIG. 9 and FIG. 10, the proportional beam splitter 417 may be a partial reflecting mirror that is at a non-perpendicular angle (for example, 45 degrees) to the laser light and has a specific transmittance (for example, 4%) or reflectivity (for example, 96%). When resonance is formed between the laser emitting apparatus and the laser receiving apparatus, because the proportional beam splitter 417 has a specific transmittance, a part of the laser light of the first wavelength reflected from the laser receiving apparatus 42 is transmitted to the detection module 415 through the proportional beam splitter 417.

The detection and control module is configured to: sequentially adjust the beam deflection module to a plurality of preset emission angles, that is, scan the laser receiving apparatus by emitting laser light in a specific area; detect light intensities of the fluorescence or the laser light at the plurality of preset emission angles, and a light spot position, of the laser light, on the detection and control module; if the light intensity is greater than a first threshold at any preset emission angle, that is, the laser light generates the resonance between the first reflecting mirror group 413 and the second reflecting mirror group 424 of the laser receiving apparatus, adjust the emission angle of the beam deflection module based on the light spot position, so that the laser light emitted by the beam deflection module is aimed at the laser receiving apparatus, that is, fine adjustment is performed. A closer light spot position to a center of the detection and control module indicates higher power of the laser light.

The detection module 415 is configured to detect a light intensity of the fluorescence or the laser light of the first wavelength and the light spot position, of the laser light, on the detection module 415. Due to an existence of the field of view range, the light spot position of the laser light irradiated on a receive surface of the detection module 415 is not fixed. The detection module 415 may include, for example, a position sensitive device (position sensitive device, PSD), an infrared camera, and a four-quadrant photoelectric detector or photodiode (photodiode, PD).

Optionally, to avoid interference of spurious light to light spot position detection, a band pass filter for the first wavelength, for example, a 1064 nm band pass filter, may be disposed on a surface of the detection module 415, or a band pass coating film for the first wavelength is grown on the surface of the detection module 415. In this way, only light near the first wavelength can be detected by the detection module 415, and light of another wavelength cannot be detected by the detection module 415.

In a possible implementation, as shown in FIG. 6 and FIG. 11, when the laser emitting apparatus 41 does not include the proportional beam splitter 417, the detection module 415 may be disposed on a light-transmitting side of the first reflecting mirror group 413. The first reflecting mirror group 413 may transmit the part of the fluorescence or the laser light of the first wavelength to the detection module 415, and the detection module 415 detects the light intensity of the fluorescence or the laser light of the first wavelength and the light spot position.

In another possible implementation, as shown in FIG. 7 to FIG. 10, when the laser emitting apparatus 41 includes the proportional beam splitter 417, the proportional beam splitter 417 is configured to transmit the part of the fluorescence or the laser light of the first wavelength to the detection module 415. The detection module 415 detects the light intensity of the fluorescence or the laser light of the first wavelength, and the light spot position, of the laser light, on the detection module 415.

The following describes a detection principle of the detection module 415.

For example, that the detection module 415 is the four-quadrant photoelectric detector is used as an example. As shown in FIG. 12, a four-quadrant photoelectric detector is a photoelectric detector device formed by arranging four PDs with identical performance based on four quadrants (A, B, C, and D) of a rectangular coordinate system. When the fluorescence or the laser light is irradiated on a surface of the four-quadrant photoelectric detector, the PD in each quadrant generates a current, and the current signal is converted into a voltage signal through an external circuit for sampling. When the fluorescence or the laser light is irradiated to a center of the four-quadrant photoelectric detector, PD output currents of the four quadrants are the same. It is assumed that the PD output current of the quadrant A is Ia, the PD output current of the quadrant B is Ib, the PD output current of the quadrant C is Ic, and the PD output current of the quadrant D is Id. Magnitude of the current corresponds to the light intensity of the fluorescence or the laser light. Coordinates $(\delta_X, \delta_Y)$ of a center of mass of the light spot are represented by Formula 1 and Formula 2 below.

$$\delta_X = \frac{(Ia + Id) - (Ib + Ic)}{Ia + Ib + Ic + Id} \quad \text{Formula 1}$$

$$\delta_Y = \frac{(Ia + Ib) - (Ic + Id)}{Ia + Ib + Ic + Id} \quad \text{Formula 2}$$

When $Ia + Id = Ic + Ib$, that is, a sum of currents on a left side of an X axis is equal to a sum of currents on a right side of the X axis, the center of mass of the light spot is located on a Y axis, that is, an X-axis coordinate of the center of mass of the light spot is represented by x = 0.

When $Ia + Ib = Ic + Id$, that is, a sum of currents on an upper side of the Y axis is equal to a sum of currents on a lower side of the Y axis, the center of mass of the light spot is located on the X axis, that is, a Y-axis coordinate of the center of mass of the light spot is represented by y = 0.

When $Ia + Id > Ib + Ic$, that is, the sum of the currents on the right side of the X axis is greater than the sum of the currents on the left side of the X axis, the center of mass of the light spot is located on a positive half axis of the X axis, that is, the X-axis coordinate of the center of mass of the light spot is represented by x > 0.

When $Ib + Ic > Ia + Id$, that is, the sum of the currents on the left side of the X axis is greater than the sum of the currents on the right side of the X axis, the center of mass of the light spot is located on a negative half axis of the X axis, that is, the X-axis coordinate of the center of mass of the light spot is represented by x < 0.

When $Ia + Ib > Ic + Id$, that is, the sum of the currents on the upper side of the Y axis is greater than the sum of the currents on the lower side of the Y axis, the center of mass of the light spot is located on a positive half axis of the Y axis, that is, the Y-axis coordinate of the center of mass of the light spot is represented by y > 0.

When $Ia + Ib < Ic + Id$, that is, the sum of the currents on the lower side of the Y axis is greater than the sum of the currents on the upper side of the Y axis, the center of mass of the light spot is located on a negative half axis of the Y axis, that is, the Y-axis coordinate of the center of mass of the light spot is represented by y < 0.

Based on the foregoing manner, the light intensity of the fluorescence or the laser light and the light spot position can be roughly obtained.

For example, that the detection module 415 is the PD is used as an example. A four-quadrant photoelectric detector may be formed by using a plurality of PDs. A principle of the four-quadrant photoelectric detector formed by using the plurality of PDs is the same as that of the four-quadrant photoelectric detector. Details are not repeated herein again.

For example, that the detection module 415 is the infrared camera is used as an example. The infrared camera sends a photographed image to the control module 414, and the control module 414 may obtain brightness of the fluorescence or the laser light of the first wavelength and the light spot position. The brightness may represent the light intensity. For example, a bright area in the image is the light spot position, and a corresponding light intensity may be obtained by extracting a brightness value of the light spot position.

For example, that the detection module 415 is the PSD is used as an example. A receive surface of the PSD is approximately a square, and a side length is L.

In a possible implementation, the PSD may output four signals: X1, X2, Y1, and Y2. X1 and X2 are voltage signals converted from photocurrents generated by light spot detection performed by two electrodes on an X axis of the PSD. Y1 and Y2 are voltage signals converted from photocurrents generated by light spot detection performed by two electrodes on a Y axis of the PSD.

In another possible implementation, the PSD may output three signals: XC, YC, and OUTH1. XC, YC, and OUTH1 have the following relationships with X1, X2, Y1, and Y2: XC = (X2 + Y1) - (X1 + Y2), YC = (X2 + Y2) - (X1 + Y1), and OUTH1 = X1 + X2 + Y1 + Y2.

A light spot position of the light spot in an X direction may be obtained by calculating XC/OUTH1 x L/2, and a light spot position of the light spot in a Y direction may be obtained by calculating YC/OUTH1 x L/2. A coordinate origin is a center of the receive surface of the PSD, and OUTH1 is an intensity of the light spot. Therefore, the detection module 415 may detect the intensity of the fluorescence or the laser light of the first wavelength and the light spot position.

Optionally, as shown in FIG. 9 to FIG. 11, the beam deflection module 416 may include a first galvanometer scanner 4161 and a second galvanometer scanner 4162. Optionally, high-reflective films for the first wavelength may be grown on surfaces of the first galvanometer scanner 4161 and the second galvanometer scanner 4162 (for example, high-reflective (high-reflective, HR) low-transmitting films). The fluorescence or the laser light of the first wavelength from the gain medium 412 is sequentially reflected by the first galvanometer scanner 4161 and the second galvanometer scanner 4162 and then emitted, and the fluorescence or the laser light of the first wavelength emitted from the laser emitting apparatus is sequentially reflected by the second galvanometer scanner 4162 and the first galvanometer scanner 4161 and then transmitted back to the gain medium 412. The control module 414 adjusts the emission angle of the beam deflection module 416 by controlling rotation angles of the first galvanometer scanner 4161 and the second galvanometer scanner 4162.

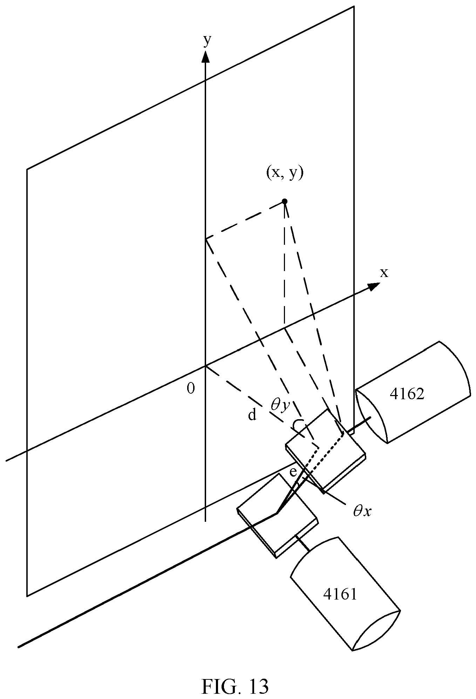

As shown in FIG. 9, when positions of the first galvanometer scanner 4161 and the second galvanometer scanner 4162 are fixed, an approximately conical fluorescence range is formed, and the field of view range is smaller than the fluorescence range. As shown in FIG. 13, it is assumed that coordinates projected by a center of the fluorescence range on a plane perpendicular to a motor rotation axis of the first galvanometer scanner 4161 are (x, y), d is a distance from the second galvanometer scanner 4162 to the plane, and e is a distance between centers of the first galvanometer scanner 4161 and the second galvanometer scanner 4162, a rotation angle $\theta x$ of the first galvanometer scanner 4161 on an X axis satisfies Formula 3, and a rotation angle of the second galvanometer scanner 4162 on a Y axis satisfies Formula 4:

$$\theta x = \arctan(\frac{x}{e + \sqrt{d^2 + y^2}}) \quad \text{Formula 3}$$

$$\theta y = \arctan(y / d) \quad \text{Formula 4}$$

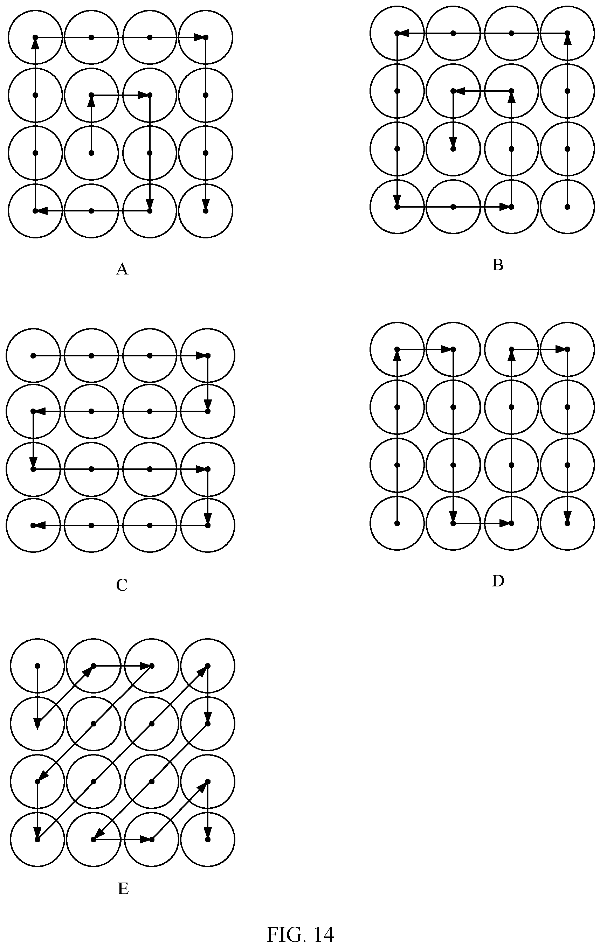

Therefore, the emission angle of the beam deflection module 416 may be adjusted by controlling the rotation angles of the first galvanometer scanner 4161 and the second galvanometer scanner 4162, to control a scanning path. For example, as shown in FIG. 14, there are several possible scanning paths. The scanning path may be scanning by step from a center to a periphery shown in A in FIG. 14, may be scanning by step from a periphery to a center shown in B in FIG. 14, may be scanning by row and by step shown in C in FIG. 14, may be scanning by column and by step shown in D in FIG. 14, or may be scanning by oblique row and by step shown in E in FIG. 14. This is not limited in this application. It should be noted that, to avoid generating a dead zone, the scanning step should be controlled, so that the scanning step is less than a width of the field of view range.

The partial reflecting mirror 419 can partially reflect the fluorescence or the laser light of the first wavelength to the gain medium 412, so that a pumping power threshold of a resonant cavity of the laser light of the first wavelength can be reduced. A light intensity of the fluorescence reflected by the partial reflecting mirror 419 is weak, and a reflectivity of the partial reflecting mirror 419 multiplied by a gain coefficient of the gain medium 412 is less than 1, so that no resonance is formed between the partial reflecting mirror 419 and the first reflecting mirror 415 when there is no reflection by the laser receiving apparatus 42. When the laser receiving apparatus 42 reflects the light of the first wavelength, a gain in the resonant cavity is greater than a loss, and resonance may be generated in the resonant cavity and the laser light of the first wavelength may be emitted.

The first lens group 418 may adjust a field of view range of the laser light of the first wavelength, and the field of view range includes a working distance and field of view of a stability zone. Stability of the resonant cavity at different distances and in different angle ranges may be changed by changing an optical parameter, for example, a focal length or a zoom-in ratio of the lens, of the first lens group 418. For example, a smaller zoom-in ratio indicates a shorter working distance of the stability zone, but a larger field of view of the stability zone. A larger zoom-in ratio indicates a longer working distance of the stability zone, but a smaller field of view of the stability zone. For another example, a longer focal length indicates a longer working distance of the stability zone, but a smaller field of view of the stability zone. A shorter focal length indicates a shorter working distance of the stability zone, but a larger field of view of the stability zone.

For example, as shown in FIG. 10, the first lens group 418 may include a convex lens F2 and a convex lens F3. A position relationship between the partial reflecting mirror 419 and each lens in the first lens group is not limited in this application. For example, the partial reflecting mirror 419 may be disposed between the convex lens F2 and the convex lens F3, disposed on a side that is close to the convex lens F2 and that is outside the first lens group, or disposed on a side that is close to the convex lens F3 and that is outside the first lens group.

Optionally, a first focus of the convex lens F2 may be located on the gain medium 412 (for example, located in a center of the gain medium 412). It should be noted that, if the laser emitting apparatus 41 includes the proportional beam splitter 417, the first focus of the convex lens F2 may be located on the gain medium 412 after being reflected by the proportional beam splitter 417. A second focus of the convex lens F2 may coincide with a first focus of the convex lens F3, and a second focus of the convex lens F3 may be located on a reflective surface of the beam deflection module 416 (for example, on a reflective surface of the first galvanometer scanner 4161).

A working principle of the laser emitting apparatus 41 is as follows:

The control module 414 controls the pump source 411 as a first pump intensity, and sequentially adjusts the beam deflection module 416 to the plurality of preset emission angles, to scan a target area. At this time, the laser emitting apparatus 41 emits the fluorescence, and this process is a coarse positioning process. Because the laser emitting apparatus 41 has a specific field of view range, when the laser receiving apparatus 42 is outside the field of view range, no resonance is formed in the resonant cavity, and no obvious light spot exists on the detection module 415.

If the control module 415 detects, through the detection module 415, that the intensity of the fluorescence or the laser light of the first wavelength is greater than the first threshold at the any preset emission angle, it is considered that the laser receiving apparatus 42 is within the field of view range of the laser emitting apparatus 41, and resonance has formed between the laser emitting apparatus 41 and the laser receiving apparatus 42. In this case, the laser emitting apparatus 41 emits the laser light, and a rough positioning process is completed. In this case, the light spot may be located at an edge position of the detection module 415. Although the laser emitting apparatus 41 also transmits energy to the laser receiving apparatus 42 through the laser light, the laser power is low.

The control module 414 controls the pump source 411 as a second pump intensity, and adjusts the emission angle of the beam deflection module 416 based on the light spot position of the laser light of the first wavelength. Specifically, the control module 414 adjusts, in a direction in which a deviation between the light spot position and a center of the detection module 415 is reduced, the emission angle of the beam deflection module 416 until an absolute value of the deviation between the light spot position and the center of the detection module 415 is less than or equal to a second threshold. For example, the second threshold may be 100 micrometers.

When the light spot position deviates from the center of the detection module 415, the detection module 415 sends the deviation to the control module 414, and the control module 414 adjusts the beam deflection module 416, so that the deviation is eliminated. That is, the control module 414 adjusts the beam deflection module 416, so that an optical axis of the laser emitting apparatus 41 faces the laser receiving apparatus 42. In this case, the light spot position is located in the center position of the detection module 415, and in this case, the laser emitting apparatus 41 transmits the energy to the laser receiving apparatus 42 through the laser light, and the laser power is the highest.

Optionally, after the beam deflection module 416 is adjusted to a target emission angle, if the control module 415 detects that the light intensity of the fluorescence or the laser light of the first wavelength is less than the second threshold, the control module 414 controls the pump source 411 as the first pump intensity, and sequentially adjusts the beam deflection module 416 to the plurality of emission angles, that is, the laser emitting apparatus 41 loses the laser receiving apparatus 42, and the coarse positioning is performed again. The second threshold is less than or equal to the first threshold.

Whether the light spot position is located in the center position of the detection module 415 may be determined in the following manner of the detection module 415:

If the detection module 415 is the four-quadrant photoelectric detector or the PD, the currents of the PD in the four quadrants are the same, that is, Ia = Ib = Ic = Id.

If the detection module 415 is the infrared camera, the bright area is located in a center of the image.

If the detection module 415 is the PSD, XC/OUTH1 x L/2 and YC/OUTH1 x L/2 are equal to coordinates of the coordinate origin.

The second pump intensity and the first pump intensity may be the same or different. In a possible implementation, the first pump intensity is less than the second pump intensity, that is, in the scanning process, the scanning is performed by using a smaller pump intensity, to reduce power consumption in the coarse positioning process. The laser emitting apparatus 41 transmits the energy to the laser receiving apparatus 42 through the laser light, and transmits the energy with large power, to improve transmission efficiency. Alternatively, the second pump intensity is adjusted based on required power fed back by the laser receiving apparatus 42.

Embodiments of this application provide a laser emitting apparatus, a laser emitting method, and a laser wireless charging system. The laser emitting apparatus includes: a control module, a detection module, a pump source, and a first reflecting mirror group, a gain medium, and a beam deflection module that are disposed in a resonant cavity. The control module is electrically connected to the detection module, the pump source, and the beam deflection module. The gain medium is pumped by the pump source to emit fluorescence, and is stimulated by resonance, between the first reflecting mirror group and a laser receiving apparatus, of the fluorescence to emit laser light. The beam deflection module emits the fluorescence or the laser light emitted by the gain medium, and emits the fluorescence or the laser light reflected by the laser receiving apparatus into the gain medium. The control module is configured to adjust the beam deflection module to a plurality of preset emission angles, the detection module is configured to detect light intensities of the fluorescence or the laser light and a light spot position, of the laser light, on the detection module, and if the light intensity is greater than a first threshold at any preset emission angle, the control module is further configured to adjust the emission angle of the beam deflection module based on the light spot position. The beam deflection module can adjust the emission angle of the laser light by a large angle, and does not need to be limited by the reflection range of the reflecting mirror and the stability of the resonant cavity. Therefore, the laser light emission range of the laser emitting apparatus can be increased.

A person of ordinary skill in the art may be aware that units and algorithm steps described with reference to embodiments disclosed in this specification can be implemented by electronic hardware, or a combination of computer software and electronic hardware. Whether these functions are performed by hardware or software depends on particular applications and design constraints of the technical solutions. A person skilled in the art may use different methods to implement the described functions for each particular application, but it should not be considered that the implementation goes beyond the scope of this application.

A person skilled in the art may clearly understand that, for convenient and brief description, for a detailed working process of the foregoing system, apparatus, and unit, refer to a corresponding process in the foregoing method embodiments. Details are not described herein again.

In the several embodiments provided in this application, it should be understood that the disclosed system, device, and method may be implemented in other manners. For example, the described device embodiment is merely an example. For example, division into the units is merely logical function division and may be other division in an actual implementation. For example, a plurality of units or components may be combined or integrated into another system, or some features may be ignored or not performed. In addition, the displayed or discussed mutual couplings or direct couplings or communication connections may be implemented through some interfaces. The indirect couplings or communication connections between the devices or units may be implemented in electronic, mechanical, or other forms.

The units described as separate components may or may not be physically separate, and components displayed as units may or may not be physical units, may be located in one position, or may be distributed on a plurality of network units. Some or all of the units may be selected based on actual requirements to achieve the objectives of the solutions of embodiments.

In addition, functional units in embodiments of this application may be integrated into one processing unit, each of the units may exist alone physically, or two or more units are integrated into one unit.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A laser emitting apparatus, comprising: a detection and control module, a pump source, and a first reflecting mirror group, a gain medium, and a beam deflection module that are disposed on an optical path, wherein

   the gain medium is pumped by the pump source to emit fluorescence, and is stimulated by resonance, between the first reflecting mirror group and a laser receiving apparatus, of the fluorescence to emit laser light;
   the beam deflection module is configured to: emit the fluorescence or the laser light emitted by the gain medium, and emit the fluorescence or the laser light reflected by the laser receiving apparatus into the gain medium; and
   the detection and control module is configured to:

      sequentially adjust the beam deflection module to a plurality of preset emission angles;
      detect light intensities of the fluorescence or the laser light at the plurality of preset emission angles, and a light spot position, of the laser light, on the detection and control module; and
      if the light intensity is greater than a first threshold at any preset emission angle, adjust the emission angle of the beam deflection module based on the light spot position, so that the laser light emitted by the beam deflection module is aimed at the laser receiving apparatus.

2. The laser emitting apparatus according to claim 1, wherein the detection and control module comprises a control module and a detection module, and the control module is configured to adjust, in a direction in which a deviation between the light spot position and a center of the detection module is reduced, the emission angle of the beam deflection module until an absolute value of the deviation between the light spot position and the center of the detection module is less than or equal to a second threshold.

3. The laser emitting apparatus according to either of claims 1 and 2, wherein the detection and control module comprises the control module, and the beam deflection module comprises a first galvanometer scanner and a second galvanometer scanner; the fluorescence or the laser light from the gain medium is sequentially reflected by the first galvanometer scanner and the second galvanometer scanner and then emitted, and the fluorescence or the laser light emitted from the laser emitting apparatus is sequentially reflected by the second galvanometer scanner and the first galvanometer scanner and then transmitted back to the gain medium; and the control module adjusts the emission angle of the beam deflection module by controlling rotation angles of the first galvanometer scanner and the second galvanometer scanner.

4. The laser emitting apparatus according to any one of claims 1 to 3, wherein the detection and control module comprises the detection module, the laser emitting apparatus further comprises a proportional beam splitter disposed on the optical path, and the proportional beam splitter is configured to transmit a part of the fluorescence or the laser light to the detection module; and the detection module is configured to detect a light intensity and a light spot position of the part of the fluorescence or the laser light.

5. The laser emitting apparatus according to claim 4, wherein the proportional beam splitter is disposed on the optical path between the gain medium and the beam deflection module.

6. The laser emitting apparatus according to claim 4, wherein the proportional beam splitter is disposed on the optical path between the first reflecting mirror group and the gain medium.

7. The laser emitting apparatus according to any one of claims 1 to 3, wherein the detection and control module comprises the detection module, the first reflecting mirror group is further configured to transmit a part of the fluorescence or the laser light to the detection module, and the detection module is configured to detect a light intensity and a light spot position of the fluorescence or the laser light.

8. The laser emitting apparatus according to any one of claims 1 to 7, wherein the laser emitting apparatus further comprises a first lens group, the first lens group is disposed on the optical path between the gain medium and the beam deflection module, and the first lens group is configured to adjust a working distance and field of view of a stability zone of the laser light.

9. The laser emitting apparatus according to any one of claims 1 to 8, wherein the laser emitting apparatus further comprises a partial reflecting mirror, the partial reflecting mirror is disposed on the optical path between the gain medium and the beam deflection module, and the partial reflecting mirror can partially reflect the fluorescence or the laser light to the gain medium.

10. The laser emitting apparatus according to any one of claims 1 to 9, wherein the pump source and the gain medium are disposed together as an electric pump semiconductor gain chip.

11. The laser emitting apparatus according to any one of claims 1 to 10, wherein the detection and control module comprises the detection module, and the detection module comprises a position sensitive device PSD, an infrared camera, and a four-quadrant photoelectric detector or photodiode.

12. The laser emitting apparatus according to any one of claims 1 to 11, wherein the first reflecting mirror group is a corner reflector, a mirror group comprising a convex lens and a planar mirror, a mirror group comprising a convex lens and a concave mirror, or a near-spherical retroreflector with a refractive index greater than or equal to 1.9 and less than or equal to 2.1.

13. A laser emitting method, applied to the laser emitting apparatus according to any one of claims 1 to 12, wherein the method comprises:

sequentially adjusting a beam deflection module of the laser emitting apparatus to a plurality of preset emission angles;

detecting light intensities of fluorescence or laser light at the plurality of preset emission angles, and a light spot position, of the laser light, on a detection and control module of the laser emitting apparatus; and
if the light intensity is greater than a first threshold at any preset emission angle, adjusting the emission angle of the beam deflection module based on the light spot position, so that laser light emitted by the beam deflection module is aimed at a laser receiving apparatus.

14. The method according to claim 13, wherein the adjusting the emission angle of the beam deflection module based on the light spot position comprises: adjusting, in a direction in which a deviation between the light spot position and a center of a detection module of the detection and control module is reduced, the emission angle of the beam deflection module until an absolute value of the deviation between the light spot position and the center of the detection module is less than or equal to a second threshold.

15. A laser wireless charging system, comprising the laser emitting apparatus and the laser receiving apparatus according to any one of claims 1 to 12, wherein the laser receiving apparatus comprises a second reflecting mirror group, a laser photovoltaic cell, a power conversion circuit, and a load circuit; the second reflecting mirror group is configured to: reflect a part of fluorescence or laser light from a beam deflection module of the laser emitting apparatus back to the beam deflection module, and transmit the other part to the laser photovoltaic cell; and the power conversion circuit is configured to: perform power conversion on electric energy from the laser photovoltaic cell, and output the electric energy to the load circuit.

11

Laser emitting
apparatus

Laser light →

12

Laser receiving apparatus

121

Laser
photovoltaic
cell

122

Power
conversion
circuit

123

Load circuit

FIG. 1

21

Pump
source

Total
reflector

Partial
reflector

22

Gain medium

Laser light →

Resonant cavity 23

FIG. 2

A

B

C

D

FIG. 3

42

Laser receiving apparatus

41

Laser emitting apparatus 411

Pump source

412

Gain medium

413

Resonant cavity

Laser light

424

421

Laser photovoltaic cell

422

Power conversion circuit

MPPT circuit

DC-DC circuit

4222

4221

423

Load circuit

FIG. 4

FIG. 5

EP 4 228 122 A1

FIG. 6

FIG. 7

FIG. 8

FIG. 9

FIG. 10

41

Laser emitting apparatus

413

415

411/412

L1

M1  F1

4162

416

4161

414

Control
module

Laser
light

Laser light of a first wavelength

FIG. 11

Y

B    A

X

C    D

FIG. 12

FIG. 13

A

B

C

D

E

FIG. 14

## INTERNATIONAL SEARCH REPORT

International application No.

**PCT/CN2021/107151**

### A. CLASSIFICATION OF SUBJECT MATTER

H02J 50/30(2016.01)i;  H01S 5/14(2006.01)i

According to International Patent Classification (IPC) or to both national classification and IPC

### B. FIELDS SEARCHED

Minimum documentation searched (classification system followed by classification symbols)

H02J,H04B,H01S

Documentation searched other than minimum documentation to the extent that such documents are included in the fields searched

Electronic data base consulted during the international search (name of data base and, where practicable, search terms used)

VEN; CNABS; CNTXT: 激光, 充电, 四象限, 无线, 传, 能, 泵浦, 偏转, 转向, 对准, 瞄准, laser, charg+, transm+, energy, power, pump+, four, wireless, aim+, trac+

### C. DOCUMENTS CONSIDERED TO BE RELEVANT

| Category* | Citation of document, with indication, where appropriate, of the relevant passages | Relevant to claim No. |
|---|---|---|
| Y | CN 102664469 A (TSINGHUA UNIVERSITY) 12 September 2012 (2012-09-12) description, paragraphs 21-26, figures 1-2 | 1-15 |
| Y | CN 103384172 A (NO. 513 RESEARCH INSTITUTE OF THE FIFTH INSTITUTE OF CHINA AEROSPACE SCIENCE AND TECHNOLOGY CORPORATION) 06 November 2013 (2013-11-06) description, paragraphs 3-43, and figures 1-3 | 1-15 |
| Y | CN 105048647 A (INSTITUTE OF ELECTRICAL ENGINEERING, CHINESE ACADEMY OF SCIENCES) 11 November 2015 (2015-11-11) description paragraphs 23-32, figures 1a-1b | 1-15 |
| Y | CN 109146919 A (GLOBAL ENERGY INTERCONNECTION RESEARCH INSTITUTE CO., LTD. et al.) 04 January 2019 (2019-01-04) description, paragraphs 32-97, and figures 1-9 | 1-15 |
| Y | CN 109094391 A (NO. 719 RESEARCH INSTITUTE, CHINA SHIPBUILDING INDUSTRY CORP.) 28 December 2018 (2018-12-28) description, paragraphs 15-26, figure 1 | 1-15 |
| Y | CN 110994814 A (TONGJI UNIVERSITY) 10 April 2020 (2020-04-10) description, paragraphs 29-76, and figures 1-7 | 1-15 |

☑ Further documents are listed in the continuation of Box C.    ☑ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **30 September 2021** | **20 October 2021** |

| Name and mailing address of the ISA/CN | Authorized officer |
|---|---|
| **China National Intellectual Property Administration (ISA/ CN)**<br>**No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**

| International application No. |
| --- |
| **PCT/CN2021/107151** |

| C. | DOCUMENTS CONSIDERED TO BE RELEVANT | | |
| --- | --- | --- | --- |
| Category* | Citation of document, with indication, where appropriate, of the relevant passages | | Relevant to claim No. |
| Y | US 2005190427 A1 (STEINSIEK FRANK et al.) 01 September 2005 (2005-09-01) description, paragraphs 21-54, and figures 1-9 | | 1-15 |
| Y | KR 102168373 B1 (UNIV SEJONG IND. ACAD COOP FOUD) 22 October 2020 (2020-10-22) description paragraphs 41-160, figures 7, 13, 23-26 | | 1-15 |

Form PCT/ISA/210 (second sheet) (January 2015)

Form PCT/ISA/210 (patent family annex) (January 2015)

**INTERNATIONAL SEARCH REPORT**
**Information on patent family members**

International application No.

**PCT/CN2021/107151**

| Patent document cited in search report | | | Publication date (day/month/year) | Patent family member(s) | | | Publication date (day/month/year) |
|---|---|---|---|---|---|---|---|
| CN | 102664469 | A | 12 September 2012 | None | | | |
| CN | 103384172 | A | 06 November 2013 | None | | | |
| CN | 105048647 | A | 11 November 2015 | None | | | |
| CN | 109146919 | A | 04 January 2019 | CN | 109146919 | B | 04 August 2020 |
| CN | 109094391 | A | 28 December 2018 | None | | | |
| CN | 110994814 | A | 10 April 2020 | None | | | |
| US | 2005190427 | A1 | 01 September 2005 | US | 7423767 | B2 | 09 September 2008 |
| | | | | DE | 502005000251 | D1 | 08 February 2007 |
| | | | | JP | 4538339 | B2 | 08 September 2010 |
| | | | | EP | 1566902 | A1 | 24 August 2005 |
| | | | | JP | 2005237012 | A | 02 September 2005 |
| | | | | EP | 1566902 | B1 | 27 December 2006 |
| | | | | DE | 102004008681 | A1 | 08 September 2005 |
| | | | | AT | 349819 | T | 15 January 2007 |
| KR | 102168373 | B1 | 22 October 2020 | WO | 2020242020 | A1 | 03 December 2020 |

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202011204598